# FASCICULE DE BREVET EUROPEEN

(11) **EP 1 308 740 B1**
(45) Date de publication et mention de la délivrance du brevet: **30.03.2011**
(21) Numéro de dépôt: 02292694.3
(22) Date de dépôt: 30.10.2002
(51) Int. Cl.: G01R 31/36

(54) **Procédé pour poser un diagnostic sur l'aptitude à fonctionner d'une batterie d'accumulateurs**
Verfahren zur Prüfung der Funktionsfähigkeit einer Speicherbatterie
Device for diagnosing the operability of a storage battery

(30) Priorité: 31.10.2001 FR 0114139
(43) Date de publication de la demande: 07.05.2003
(73) Titulaire: RENAULT S.A.S., 92100 Boulogne Billancourt (FR)
(72) Inventeur: Bogel, Wolfgang, 75014 Paris (FR); Hiron, Christian, 78690 Les Essarts Le Roi (FR); Menourie, Sébastien, 91150 Etampes (FR)
(74) Mandataire: Religieux, Vincent

(56) Documents cités:
- EP-A- 0 272 780
- US-B1- 6 259 254
- PATENT ABSTRACTS OF JAPAN vol. 008, no. 092 (P-271), 27 avril 1984 (1984-04-27) & JP 59 007276 A (NIHON JIDOUSHIYA SEIBI SHIYOUKOU KUMIAI RENGOUKAI;OTHERS: 01), 14 janvier 1984 (1984-01-14)
- PATENT ABSTRACTS OF JAPAN vol. 1999, no. 12, 29 octobre 1999 (1999-10-29) & JP 11 178233 A (NISSAN MOTOR CO LTD), 2 juillet 1999 (1999-07-02)

## Description

La présente invention est relative à un dispositif destiné à poser un diagnostic concernant l'aptitude à fonctionner d'une source d'énergie et de puissance électrique à accumulation. Plus particulièrement, l'invention concerne un tel dispositif qui par détection de la perte de puissance d'une chaîne de démarrage du moteur d'entraînement d'un véhicule automobile, permet de poser un diagnostic sur l'aptitude à fonctionner de la batterie d'accumulateurs d'un véhicule automobile.

A l'heure actuelle, les véhicules automobiles ne disposent d'aucun moyen permettant de connaître l'état de la batterie utilisée en particulier pour fournir l'énergie et la puissance électrique à la chaîne de démarrage du véhicule. On connaît bien les indicateurs de batterie prévus sur le tableau de bord de la plupart des véhicules. Cependant, ces indicateurs fournissent une information non pas sur l'aptitude à fonctionner de la batterie, mais sur celle de l'alternateur qui fournit l'énergie électrique au véhicule lorsque le moteur tourne.

Une batterie, qu'elle soit au lithium, à technologie alcaline ou, plus classiquement, au plomb-acide, utilisée comme source d'énergie et de puissance au démarrage d'un véhicule automobile, est un composant fragile dont la durée de vie, relativement courte et imprévisible, dépend fortement du type d'utilisation et de la position dans le véhicule (exposition à la chaleur du moteur, par exemple). C'est ainsi que la durée de vie d'une batterie peut être très variable et se situer entre 1 et 10 ans.

Comme la batterie est indispensable pour fournir l'énergie et la puissance de démarrage, sa défaillance a pour conséquence une panne immobilisante du véhicule. En général, il est remédié à une telle panne par le remplacement pur et simple de la batterie. Il serait donc hautement souhaitable que l'on puisse doter les véhicules automobiles d'un dispositif fiable permettant de poser un diagnostic sur l'aptitude à fonctionner de la batterie, non pas lorsque la perte de puissance de celle-ci provoque l'immobilisation du véhicule, mais bien plus prématurément de sorte que l'utilisateur puisse prévoir la nécessité du remplacement de la batterie.

Dans la technique antérieure, on connaît de nombreux dispositifs de contrôle de batteries.

La plupart de ces dispositifs (voir par exemple US 4 888 716) sont basés sur le principe qui consiste à mesurer une variation de tension par rapport à une variation de courant à une température donnée de la batterie et à en déduire une image de la résistance interne de la batterie. Cette image est alors comparée à une table caractéristique mémorisée contenant des valeurs de la résistance interne relevées pendant la première utilisation à pleine charge. Au cours de l'utilisation, on observe ensuite les écarts entre les valeurs initiales et les valeurs des résistances internes calculées à partir des valeurs mesurées instantanées de courant et de tension, et le dispositif déduit l'aptitude à fonctionner de la batterie en fonction de ces écarts.

Un tel dispositif est complexe et onéreux, comparé au prix généralement modeste de la batterie, notamment en raison du fait qu'il faut un capteur de courant relativement précis. De plus, pour donner un résultat fiable, la table caractéristique du dispositif doit être relevée pour une batterie donnée et elle ne peut guère être généralisée pour une série de batteries de même type.

Le document EP-A-0272780 décrit un procédé de diagnostic d'une chaîne de démarrage au cours duquel, pendent le démarrage, on mesure la tension sur le démarreur et cette tension est comparée à une valeur de tension mémorisée représentant la capacité requise de la batterie à une température minimale de fonctionnement.

L'invention a pour but de fournir un procédé destiné a diagnostiquer une batterie d'accumulateur avec une fiabilité meilleure que celle obtenue avec les procédés de la technique antérieure et ce moyennant un équipement simple et de faible coût.

L'invention a donc pour objet un procédé pour diagnostiquer l'aptitude à fonctionner d'une batterie d'accumulateurs pour véhicule automobile comprenant l'association d'un moteur à combustion interne, d'une chaîne de démarrage et de ladite batterie, celle-ci fournissant l'énergie et la puissance à ladite chaîne de démarrage, caractérisé en ce qu'il consiste
à établir le diagnostic de ladite batterie sur la base de l'évolution, croissante au cours de l'utilisation de ladite batterie, d'une température minimale de démarrage à laquelle est atteinte une vitesse préfixée de démarrage électrique dudit moteur à combustion interne, au minimum nécessaire pour son démarrage par combustion interne.

Grâce à ces caractéristiques, le diagnostic concernant l'aptitude à fonctionner de la batterie peut être posée par l'utilisation de paramètres disponibles de toute manière dans une association d'une batterie d'une chaîne de démarrage et d'un moteur à combustion interne, le matériel nécessaire à l'exécution du procédé étant simple et de faible coût. En particulier, il n'et pas nécessaire de mesurer le courant circulant dans la batterie.

Selon d'autres particularités avantageuses de l'invention,
- le procédé consiste
   a) à mémoriser, pour une association donnée d'un type de batterie, d'un type de chaîne de démarrage et d'un type de moteur à combustion interne, une courbe de référence tracée pour ladite batterie à l'état neuf, en fonction d'une pluralité de couples de valeurs de température de démarrage et de vitesse de rotation de démarrage électrique, cette courbe de référence comprenant notamment un couple de valeurs incluant ladite vitesse préfixée et ladite température minimale,
   b) au cours d'au moins un démarrage de ladite association, à relever un couple de valeurs actuelles de température de démarrage et de vitesse de rotation de démarrage électrique dudit moteur,
   c) à calculer sur la base d'une courbe de couples de valeurs, homothétique de ladite courbe de référence, sur laquelle est placé ledit couple de valeurs actuelles, la nouvelle température minimale de démarrage à laquelle serait atteinte ladite vitesse préfixée, et
   d) à poser un diagnostic sur l'aptitude à fonctionner de ladite batterie en fonction de l'écart entre la valeur de température minimale de ladite courbe de référence et la nouvelle température minimale calculée;
- ladite association d'une batterie, d'une chaîne de démarrage et d'un moteur à combustion interne venant d'être constituée à partir de composants neufs, le procédé consiste également à tracer expérimentalement ladite courbe de référence sur au moins un exemplaire d'une telle association;
- ladite association d'une batterie, d'une chaîne de démarrage et d'un moteur à combustion interne venant d'être constituée à partir de composants neufs, le procédé consiste à l'occasion de cette constitution, à mémoriser une courbe typique empirique formée d'une pluralité de couples de valeurs composés chacun d'une température et d'une valeur relative de vitesse de démarrage électrique se trouvant expérimentalement associée à cette température, à mémoriser ladite courbe de référence au cours d'une période d'apprentissage consécutive à ladite constitution en déterminant pendant un nombre de démarrages prédéterminé des couples actuels d'apprentissage de température et de vitesse de démarrage électrique, à calculer sur une courbe homothétique de ladite courbe typique et à partir d'au moins certains desdits couples actuels d'apprentissage ainsi relevés, des couples respectifs de sévérité maximale composés de valeurs représentatives de ladite température minimale et de ladite vitesse préfixée, à établir la moyenne des valeurs de température desdits couples respectifs de température minimale et de vitesse préfixée et à caler ladite courbe de référence par homothétie par rapport à ladite courbe typique, sur la moyenne ainsi obtenue;
- ladite période d'apprentissage s'étend sur un nombre de démarrages situé entre 20 et 100;
- le procédé consiste à caler ladite courbe de référence sur ladite moyenne, lorsque l'écart entre la moyenne établie pendant un démarrage donné et celle de la moyenne établie au cours du premier démarrage pris en compte se réduit en deçà d'un seuil prédéterminé;
- la valeur dudit écart restant au delà dudit seuil pendant un nombre prédéterminé de démarrages, il est procédé à l'établissement d'une nouvelle moyenne initiale et ladite courbe de référence est calée lorsque l'écart entre la moyenne établie pendant un démarrage donné et celle de la nouvelle moyenne initiale se réduit en deçà d'un seuil prédéterminé;
- le procédé consiste à émettre un message de défaut, lorsque le nombre de moyennes initiales calculées dépasse une valeur prédéterminée;
- le procédé consiste à ne prendre en compte des couples de valeurs obtenus pendant des démarrages effectués après écoulement d'une période de rodage de ladite association de batterie, de chaîne de démarrage et de moteur à combustion interne;
- le procédé consiste à ne prendre en compte des couples de valeurs obtenus pendant des démarrages survenant après une période de repos de durée prédéterminée de ladite association de batterie, de chaîne de démarrage et de moteur à combustion interne de façon à ce que tous les composants de cette association aient la même température;
- le procédé consiste à ne prendre en compte des couples de valeurs obtenus pendant des démarrages pour lesquels la tension en circuit ouvert de ladite batterie indique une charge de celle-ci jugée suffisante;
- ladite période de repos est choisie entre 4 et 24 heures;
- ledit moteur étant de type à allumage commandé, ladite vitesse préfixée de démarrage électrique est de 100 tours/minute, par exemple;
- ledit moteur étant de type Diesel, ladite vitesse préfixée de démarrage électrique est de 130 tours/minutes, par exemple.

D'autres caractéristiques et avantages de la présente invention apparaîtront au cours de la description qui va suivre, donnée uniquement à titre d'exemple et faite en se référant aux dessins annexés sur lesquels:

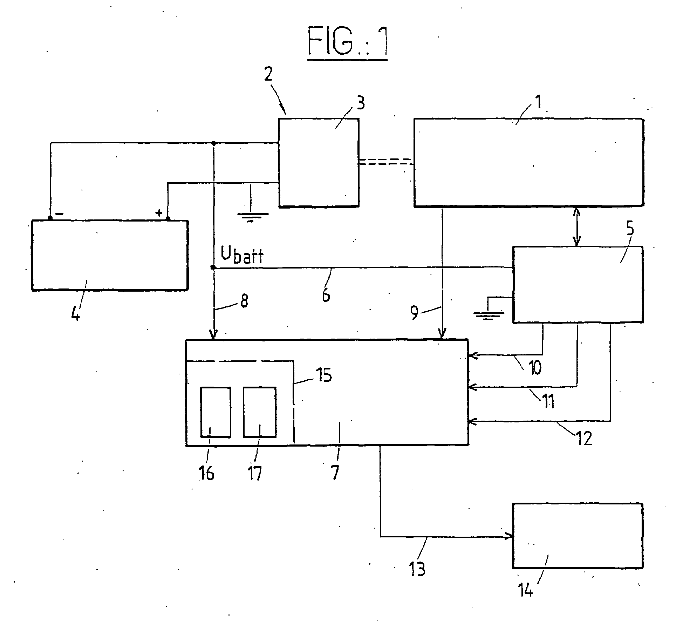

- la figure 1 est un schéma très simplifié de l'association d'une batterie, d'une chaîne de démarrage et d'un moteur à combustion interne, association qui équipe un véhicule automobile, et qui comporte en outre un dispositif de diagnostic de batterie permettant de mettre en oeuvre le procédé selon l'invention;

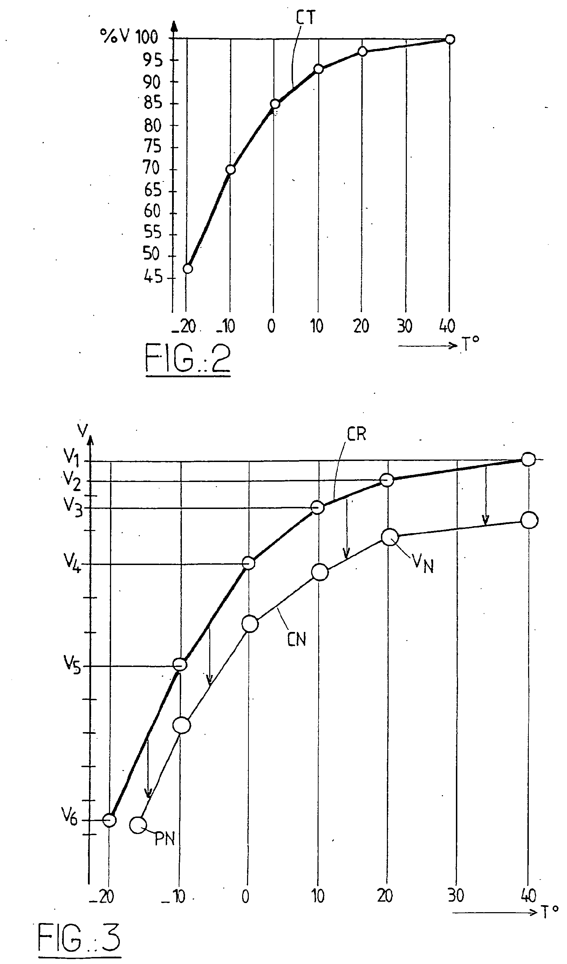

- la figure 2 est un graphe montrant une courbe empirique typique illustrant des couples de valeurs relatives de température et de vitesses de démarrage électrique, cette courbe étant reperésentative des associations de chaînes de démarrage, de moteurs à combustion interne et de batteries d'accumulateurs pour véhicule automobile;
- la figure 3 est un graphe illustrant le procédé de diagnostic selon l'invention.

L'invention est basée sur les constatations suivantes.
a) Il existe une valeur limite de vitesse de rotation électrique d'un moteur à combustion interne au-dessous de laquelle ce dernier ne peut déclencher le processus de combustion et donc démarrer. Il s'avère que cette vitesse limite est constante dans le temps, quelle que soit la température de la chaîne de démarrage, et ce au moins pendant au moins les trois premières années d'utilisation du véhicule.
Ainsi, on a pu déterminer que pour un moteur à allumage commandé, cette vitesse est de 100 t/min par exemple, tandis que pour un moteur Diesel, elle est de 130 t/min, par exemple. Par conséquent, les constructeurs de véhicules automobiles font en sorte que la chaîne de démarrage puisse au minimum faire tourner le moteur non encore démarré à une telle vitesse électrique dans les conditions les plus sévères de température fixées typiquement à -20°C.
b) La résistance à la rotation d'un moteur à combustion interne se stabilise après la période de rodage du véhicule qui en est équipé, c'est-à-dire après environ 1000km de parcours du véhicule à la suite de sa mise en circulation. Cette résistance à la rotation reste constante par la suite et ne dépend en fait que du type d'huile de lubrification utilisée et de la température du moteur. Ceci vaut surtout pour les trois premières années d'utilisation du véhicule. Ensuite, la résistance à la rotation peut diminuer, mais en contrepartie, la résistance de la chaîne mécanique couplée au moteur augmente à peu près dans les mêmes proportions. En première approximation, on peut donc considérer que le moteur du véhicule impose au démarrage à la batterie une demande de puissance à peu près constante au delà d'une période de rodage d'environ 1000 km.
c) En général, un moteur à combustion interne démarre après que deux ou trois compressions aient eu lieu dans ses cylindres. Avant la compression qui déclenche le démarrage, l'entraînement du moteur est assuré par la chaîne de démarrage avec comme seule source la batterie de laquelle le moteur puise son énergie et sa puissance pour tourner.
Pour la commodité du présent exposé, on appellera "vitesse de démarrage électrique" la vitesse à laquelle le moteur est entraîné pendant les premières compressions. Elle est mesurable par le calculateur qui gère le fonctionnement du moteur. Ce calculateur peut communiquer cette vitesse par exemple au moment où la deuxième compression a lieu.
d) La Demanderesse a également observé que pendant que le moteur à combustion interne subit l'entraînement électrique de la part de la chaîne de démarrage, sa vitesse de démarrage électrique dépend de la température selon une courbe typique, toujours à peu près de même forme, que la Demanderesse a pu relever sur de nombreuses associations formées d'une batterie d'accumulateur de type donné et d'un moteur à combustion interne donné équipé de sa chaîne de démarrage. Bien que ces mesures aient présenté une certaine dispersion d'une association batterie-chaîne-moteur à l'autre, la courbe présente toujours à peu près la forme de la courbe CT représentée sur la figure 2. Cette courbe a été tracée sur la base du tableau ci-dessous répertoriant quelques couples de valeurs C1 à C6 d'une température de chaîne de démarrage et d'une vitesse relative électrique de démarrage, étant entendu que, sur la courbe, la vitesse relative de démarrage pour une température de 40°C de la chaîne de démarrage est représentative de 100%:

| Couple de valeurs | Température de la chaîne de démarrage | Moyenne de la vitesse électrique de démarrage du moteur (%) |
|---|---|---|
| C1 | 40 | 100 |
| C2 | 20 | 97 |
| C3 | 10 | 92 |
| C4 | 0 | 84 |
| C5 | -10 | 70 |
| C6 | -20 | 45 |

Or, selon une propriété constatée au cours des études menées par la Demanderesse, il s'est avéré également que, au fur et à mesure de l'utilisation d'une batterie d'accumulateurs, la puissance potentielle de cette dernière se dégrade et que la courbe typique définie ci-dessus se déplace de façon homothétique, de telle façon que la vitesse minimale de démarrage ne peut être atteinte que pour une température plus élevée que la température minimale initialement déterminée.
Il convient de souligner que la forme exacte de la courbe typique peut varier légèrement d'une association type de batterie/type de moteur à l'autre, mais la forme générale est la même dans tous les cas, de même que le déplacement homothétique de la courbe typique est toujours observé en fonction du vieillissement de la batterie.
e) L'état de charge d'une batterie d'accumulateurs peut être exprimé sous la forme de la valeur de la tension à ses bornes en circuit ouvert à condition que la mesure de cette tension se fasse après une période de temps pendant laquelle la batterie reste au repos, période dont la durée peut être située entre 4 et 24 heures. Par ailleurs, la tension en circuit ouvert est pratiquement indépendante de la température. Ainsi, pour une batterie au plomb courante, si on mesure 11,5V en circuit ouvert au bout de huit heures de repos de la batterie, son état de charge sera de 0%. En revanche, si on mesure dans ces conditions une tension de 12,8V, on peut considérer que la batterie est chargée à 100%.
f) Alors qu'en fonctionnement du véhicule, le moteur à combustion interne, la batterie et les différents organes du véhicule prennent des températures très diverses, on peut estimer que cette température est uniforme pour tous ces composants, après un certain temps de non utilisation du véhicule. On peut estimer de 8 à 24 heures, environ le temps nécessaire pour que cette uniformité thermique soit atteinte.
g) la dégradation de la puissance d'une batterie étant relativement lente, un diagnostic sur son aptitude à fonctionner peut déjà être utile s'il est disponible avec une fréquence relativement lente, mensuelle par exemple.

On va maintenant décrire un mode de mise en oeuvre du procédé de diagnostic selon l'invention en se référant d'abord à la figure 1.

Sur cette figure, un véhicule automobile comprend l'association d'un moteur à combustion interne 1, d'une chaîne de démarrage 2 comprenant notamment un démarreur 3 et d'une batterie d'accumulateurs 4 dont il s'agit d'établir un diagnostic. Le moteur 1 peut être du type à allumage commandé ou du type à Diesel. La batterie peut être de tout type connu, la batterie au plomb étant, bien entendu, la plus répandue.

De la façon habituelle, la batterie 4 est connectée à un réseau électrique du véhicule et à un alternateur, éléments qui n'ont pas été représentés, car ils ne sont pas en rapport direct avec l'invention.

Le moteur 1 est commandé par un calculateur de commande 5 connu en soi, recevant son alimentation électrique de la batterie d'accumulateurs 4. Le conducteur de connexion 6 assurant cette alimentation est au potentiel des bornes de la batterie 4 que l'on pourra utiliser comme valeur de mesure pour la tension en circuit ouvert U_{batt} de cette batterie dans des conditions de mesure particulières encore à décrire.

Un dispositif 7 permet de diagnostiquer l'aptitude à fonctionner de la batterie 4. Il reçoit les signaux d'entrée suivants:
- sur un conducteur 8 la tension U_{batt} déjà mentionnée,
- sur un conducteur 9, la température Tₘₒₜ du moteur à combustion interne, par exemple la température de l'eau de refroidissement de ce moteur,
- sur un conducteur 10, un signal de fin de rodage que le calculateur 5 est à même de produire lorsque le véhicule a parcouru un nombre de kilomètres prédéterminé (1000km par exemple) à partir de sa mise en service,
- sur un conducteur 11, un signal représentant le temps écoulé depuis le dernier démarrage, lorsque ce temps est supérieur à un intervalle prédéterminé (huit heures par exemple), et
- sur un conducteur 12, la valeur actuelle de la vitesse de démarrage électrique.

Le dispositif de diagnostic 7 fournit un signal de sortie sur un conducteur 13 menant à un dispositif d'affichage 14 sur lequel l'information de diagnostic peut être rendue perceptible par tout moyen approprié, de préférence sur le tableau de bord du véhicule.

Dans le mode de mise en oeuvre préféré du procédé de diagnostic selon l'invention, le dispositif de diagnostic 7 comporte des moyens de mémorisation 15 comprenant une première table caractéristique 16 dans laquelle est déposée, en fin de chaîne de fabrication, une courbe typique relevée expérimentalement. Cette courbe peut être celle désignée par CT sur la figure 2; elle est composée de couples de valeurs C1 à C6 (ou de façon plus affinée, d'un nombre bien plus grand de ces couples de valeurs). Chacun des couples C1 à C6 de la courbe CT est composé à son tour d'une valeur relative de vitesse de rotation de démarrage électrique et d'une valeur associée de température à laquelle le démarrage du moteur 1 a lieu.

Comme il sera décrit plus en détail par la suite, dans le mode de mise en oeuvre préféré du procédé de l'invention, cette courbe typique CT servira à déterminer par le calcul et par homothétie une courbe de référence CR (figure 3) dont les couples de valeurs seront déposés dans une seconde table 17 des moyens de mémorisation 15, cette courbe de référence CR basée sur des valeurs de vitesse de démarrage électrique réelles étant déterminée au cours d'un processus d'apprentissage exécuté en début d'utilisation du véhicule automobile.

Ce mode de mise en oeuvre préféré du procédé de l'invention permet ainsi de tenir compte des propriétés spécifiques (câblages différents ayant une influence sur la résistance interne de la batterie 4, par exemple), de l'association batterie-chaîne de démarrage-moteur à combustion interne effectivement utilisée dans le véhicule.

Cependant, en sacrifiant quelque peu la précision du diagnostic de la batterie, il est également possible d'utiliser pour le procédé de l'invention une courbe de référence CR déterminée expérimentalement par exemple pour un type donné d'associations batterie-chaîne de démarrage-moteur, cette courbe de référence pouvant alors être déposée dans une unique table des moyens de mémorisation 15 dès la sortie de chaîne de fabrication du véhicule automobile.

Cependant, selon une variante d'exécution, visant, dans le cas plus simple qui vient d'être exposé, à rendre le dispositif de diagnostic d'un emploi général pour toutes sortes d'associations batterie-chaîne de démarrage-moteur, il est également possible de déposer dans les moyens de mémorisation 15 plusieurs courbes de référencé CR propres chacune à une association donnée et d'appeler la courbe adéquate correspondant à l'association concernée équipant le véhicule dès sa sortie de chaîne de fabrication.

Ceci étant précisé, on va maintenant décrire le mode de mise en oeuvre du procédé de l'invention dans lequel la courbe de référence CR est obtenue par apprentissage durant la première période d'utilisation du véhicule. Il va de soi que ce procédé offre la précision de diagnostic la plus grande comparée à celle des variantes de mise en oeuvre décrites ci-dessus, qui offrent néanmoins des résultats de diagnostic exploitables.

Les couples de valeurs de la courbe CT de la figure 2 sont introduites dans la table 16 en fin de chaîne de fabrication du véhicule.

Le procédé mis en oeuvre dans le dispositif de diagnostic 7 peut alors exécuter une première étape consistant à interroger le calculateur de commande 5 concernant les identifications des composants de l'association batterie-chaîne de démarrage-moteur utilisée dans le véhicule.

Puis, le dispositif de diagnostic 7 est désactivé et sa réactivation n'intervient qu'après écoulement d'une période de rodage prédéterminée du véhicule. Cette période peut être déterminée par le calculateur 5 et être fixée, par exemple à un nombre de kilomètres parcourus après la mise en service du véhicule. Le nombre peut être égal à 1000 km, par exemple.

L'activation du dispositif de diagnostic 7 déclenche une phase d'apprentissage (auto-apprentissage) au cours de laquelle la courbe typique CT est utilisée pour engendrer et mémoriser la courbe de référence CR de la figure 3. On rappelle que la courbe de référence est déterminée par des couples de valeurs température-vitesse de démarrage électrique dans lesquels la vitesse est exprimée en tours par minutes telles que par exemple les vitesses V1 à V6 de la figure 3. Le relevé de la courbe de référence CR permet d'adapter le dispositif de diagnostic 7 aux dispersions de construction de l'association utilisée dans le véhicule, comme par exemple celles provoquées par le câblage qui influe sur la résistance interne de la batterie 4.

Pendant la période d'apprentissage, au fur et à mesure des démarrages du véhicule, le dispositif de diagnostic 7 enregistre une mesure du couple température de démarrage-vitesse de démarrage électrique effectivement présent au moment du démarrage considéré. Chaque couple de valeurs ainsi relevé est placé dans la table caractéristique 17. La sélection des démarrages dont les paramètres seront ainsi mémorisés se fait avantageusement selon une ou plusieurs conditions qui peuvent être les suivantes:
- les démarrages effectués lorsque la température de l'association des composants 1, 3 et 4 se soit stabilisée. Avantageusement, on ne prend en compte que les démarrages ayant lieu au minimum huit heures après le démarrage précédent, le nombre de huit étant naturellement indicatif.
- les démarrages qui ont lieu alors que la batterie présente une charge jugée suffisante, par exemple la pleine charge. A cet effet, le dispositif de diagnostic 7 mesure la tension en circuit ouvert U_{batt} de la batterie 4 et ne prend en compte les paramètres de démarrage que lorsque cette tension correspond à la charge suffisante de la batterie. A titre d'exemple, pour une batterie au plomb la prise en compte se fait seulement lorsque lors du démarrage il est constaté que la tension en circuit ouvert U_{batt} est supérieure à 12,8 Volts.

Il est à noter que les conditions décrites ci-dessus que l'on appellera "conditions nominales" par la suite, valent pour. le relevé des paramètres de démarrage tant pendant la phase d'apprentissage que pendant la phase de diagnostic encore à décrire.

Les données correspondant aux conditions décrites ci-dessus sont fournies au dispositif de diagnostic 7 par l'intermédiaire des conducteurs 9 à 12.

Le dispositif de diagnostic 7 connaissant la vitesse minimale de démarrage électrique, ce dont il a été informé auparavant lorsque le véhicule quittait la chaîne de fabrication, procède au calage d'une courbe de référence CR sur la forme de la courbe typique CT par calcul homothétique, en créant des valeurs de vitesse de démarrage électrique réelles, telles que par exemple les valeurs V1 à V6 de la figure 3.

Un exemple de mise en oeuvre préféré de cette étape du procédé peut se dérouler comme suit.

Pour un premier nombre (dix par exemple) de relevés de couples de valeurs faits sur des démarrages effectués dans les conditions nominales, on calcule chaque fois, en utilisant l'homothétie sur les formes des courbes, la température à laquelle on pourrait faire démarrer le moteur à la vitesse de démarrage électrique minimale imposée par construction.

Par exemple, si la température au démarrage est de 20°C et si on mesure une vitesse de démarrage électrique de 215 t/min (valeur V2, figure 3), on pourra déduire, sur la base de la forme de la courbe typique CT, que la vitesse de démarrage électrique minimale (100 t/min) peut être obtenue à -20°C (valeur V6 de la figure 3).

Sur le premier nombre de démarrages, on calcule ainsi ces températures minimales et on établit la moyenne sur ces valeurs.

Lors des démarrages suivants faits dans les mêmes conditions nominales, les valeurs de température minimale ou leur moyenne sont comparées à la première valeur de moyenne obtenue.

Si l'écart résultant de cette comparaison n'excède pas un seuil prédéterminé (5%, par exemple), on considère que la valeur obtenue de température minimale est suffisamment fiable pour que l'on puisse calculer, de nouveau par homothétie sur la courbe typique, la courbe de référence CR en prenant comme base la valeur de température minimale résultant de toutes les mesures. La courbe de référence CR est alors déposée dans la table caractéristique 17 du dispositif de diagnostic 7 et la phase d'apprentissage du procédé prend fin.

En revanche, si l'écart excède le seuil, on en conclut que le dispositif de diagnostic 7 n'a pas encore détecté la température minimale de démarrage à laquelle la vitesse minimale de démarrage électrique peut être obtenue. Dans ce cas, le procédé peut prévoir une nouvelle itération d'apprentissage visant à obtenir une température minimale de démarrage.

Si une telle valeur de température ne peut être obtenue au bout d'un nombre prédéterminé (trois par exemple) d'itérations de la phase d'apprentissage, un signal de défaut peut être engendré et rendu perceptible sur le dispositif d'affichage 14.

Si la courbe de référence CR peut être obtenue dans de bonnes conditions et déposée dans la table caractéristique 17, le procédé peut passer à la phase de diagnostic proprement dite et la température minimale de démarrage obtenue en fin d'apprentissage, être affichée sur le dispositif d'affichage 14 en tant que première valeur de diagnostic de l'aptitude à fonctionner de la batterie 4.

Au cours de la phase de diagnostic, à chaque démarrage effectué dans les conditions nominales, le dispositif de diagnostic 7 relève les couples réels de valeurs de température et de vitesse de démarrage électrique et recalcule la température minimale de démarrage en utilisant la courbe de référence CR déposée dans la table caractéristique 17. Il est clair que, sauf incident de fonctionnement de la batterie 4, la température minimale de démarrage recalculée sera identique à celle de la courbe de référence. Par exemple, dans l'exemple ci-dessus, cette température sera de -20°C.

Cependant, au fur et à mesure de son utilisation ou pour une autre raison survenant plus ou moins brusquement, la batterie 4 subira une dégradation de son aptitude au fonctionnement. Il est donc probable qu'il arrive un moment où un démarrage fait dans les conditions nominales conduira au relevé d'un couple de valeurs de température et de vitesse de démarrage électrique qui s'écarte de la courbe de référence CR. Par exemple, si pour un de ces démarrages effectué à une température de 21,5°C, la vitesse de démarrage électrique n'est plus que de 194 t/min (valeur VN), le calcul par homothétie par rapport à la courbe de référence CR, aboutira à une nouvelle courbe de couples de valeurs (par exemple la courbe CN de la figure 3) sur laquelle il s'avérera que la vitesse minimale de démarrage (fixée à 100 t/min) ne pourra être atteinte qu'à -18°C (point PN de la courbe CN). Cette nouvelle valeur de température minimale de démarrage sera affichée sur le dispositif d'affichage 14 en tant qu'indication de la dégradation de la batterie 4.

On comprend ainsi que l'évolution de la température minimale de démarrage observée sur le dispositif d'affichage permet de constater le degré de dégradation de la batterie 4 de sorte que si cette température évolue vers le haut vers une température donnée, on pourra conclure qu'un remplacement de la batterie devient souhaitable. On dispose ainsi d'une information de diagnostic facile à exploiter, même pour le profane sans qu'il soit nécessaire d'utiliser des composants coûteux.

Bien entendu, l'information de température minimale pourra être affichée sous de nombreuses formes, par exemple par des icônes, une échelle sur laquelle se déplace un indicateur etc., sans qu'il soit besoin d'afficher la valeur réelle de la température minimale de démarrage.

## Revendications

1. Procédé pour diagnostiquer l'aptitude à fonctionner d'une batterie d'accumulateurs (4) pour véhicule automobile comprenant l'association d'un moteur à combustion interne (1), d'une chaîne de démarrage (2) et de ladite batterie (4), celle-ci fournissant l'énergie et la puissance à ladite chaîne de démarrage (2), de sorte que ladite chaîne de démarrage puisse au minimum faire tourner ledit moteur à combustion interne (1) à une vitesse minimale de démarrage préfixée, à une température minimale de démarrage initialement déterminée, **caractérisé en ce qu'**il consiste
à recalculer, au fur et à mesure des démarrages du véhicule, une nouvelle température minimale de démarrage à laquelle serait atteinte ladite vitesse minimale de démarrage préfixée, de sorte à établir le diagnostic de ladite batterie sur la base de l'évolution, croissante au cours de l'utilisation de ladite batterie, de ladite nouvelle température minimale de démarrage recalculée.

2. Procédé suivant la revendication 1, **caractérisé en ce qu'**il consiste:
a) à mémoriser, pour une association donnée d'un type de batterie (4), d'un type de chaîne de démarrage (2) et d'un type de moteur à combustion interne (1), une courbe de référence (CR) tracée pour ladite batterie à l'état neuf, en fonction d'une pluralité de couples de valeurs de température de démarrage et de vitesse de rotation de démarrage électrique, cette courbe de référence comprenant notamment un couple de valeurs incluant ladite vitesse préfixée et ladite température minimale,
b) au cours d'au moins un démarrage de ladite association, à relever un couple de valeurs actuelles de température de démarrage et de vitesse de rotation de démarrage électrique dudit moteur,
c) à calculer sur la base d'une courbe de couples de valeurs, homothétique de ladite courbe de référence (CR), sur laquelle est placé ledit couple de valeurs actuelles, la nouvelle température minimale de démarrage à laquelle serait atteinte ladite vitesse préfixée, et
d) à poser un diagnostic sur l'aptitude à fonctionner de ladite batterie (4) en fonction de l'écart entre la valeur de température minimale de ladite courbe de référence (CR) et la nouvelle température minimale calculée.

3. Procédé suivant la revendication 2, **caractérisé en ce que**, ladite association d'une batterie (4), d'une chaîne de démarrage (2) et d'un moteur à combustion interne (1) venant d'être constituée à partir de composants neufs, il consiste à tracer expérimentalement ladite courbe de référence (CR) sur un exemplaire d'une telle association.

4. Procédé suivant la revendication 2, **caractérisé en ce que**, ladite association d'une batterie (4), d'une chaîne de démarrage (2) et d'un moteur à combustion interne (1) venant d'être constituée à partir de composants neufs, il consiste à l'occasion de cette constitution, à mémoriser une courbe typique empirique (CT) formée d'une pluralité de couples de valeurs composés chacun d'une température et d'une valeur relative de vitesse de démarrage électrique se trouvant expérimentalement associée à cette température,
à mémoriser ladite courbe de référence (CR) au cours d'une période d'apprentissage consécutive à ladite constitution en déterminant pendant un nombre de démarrages prédéterminé des couples actuels d'apprentissage de température et de vitesse de démarrage électrique,
à calculer sur une courbe homothétique de ladite courbe typique et à partir d'au moins certains desdits couples actuels d'apprentissage ainsi relevés, des couples respectifs composés de valeurs représentatives de ladite température minimale et de ladite vitesse préfixée,
à établir la moyenne des valeurs de température desdits couples respectifs de température minimale et de vitesse préfixée et
à caler ladite courbe de référence (CR) par homothétie par rapport à ladite courbe typique (CT), sur la moyenne ainsi obtenue.

5. Procédé suivant la revendication 4, **caractérisé en ce que** ladite période d'apprentissage s'étend sur un nombre de démarrages situé entre 20 et 100.

6. Procédé suivant l'une quelconque des revendications 2 à 5, **caractérisé en ce qu'**il consiste à caler ladite courbe de référence (CR) sur ladite moyenne, lorsque l'écart entre la moyenne établie pendant un démarrage donné et celle de la moyenne établie au cours du premier démarrage pris en compte se réduit en deçà d'un seuil prédéterminé.

7. Procédé suivant la revendication 6, **caractérisé en ce que**, la valeur dudit écart restant au delà dudit seuil pendant un nombre prédéterminé de démarrages, il est procédé à l'établissement d'une nouvelle moyenne initiale et ladite courbe de référence (CR) est calée lorsque l'écart entre la moyenne établie pendant un démarrage donné et celle de la nouvelle moyenne initiale se réduit en deçà d'un seuil prédéterminé.

8. Procédé suivant la revendication 7, **caractérisé en ce qu'**il consiste à émettre un message de défaut, lorsque le nombre de moyennes initiales calculées dépasse une valeur prédéterminée.

9. Procédé suivant l'une quelconque des revendications 2 à 8, **caractérisé en ce qu'**il consiste à ne prendre en compte que des couples de valeurs obtenus pendant des démarrages effectués après écoulement d'une période de rodage de ladite association de batterie (4), de chaîne de démarrage (2) et de moteur à combustion interne (1), de façon à ce que tous les composants de cette association aient la même température.

10. Procédé suivant l'une quelconque des revendications 2 à 9, **caractérisé en ce qu'**il consiste à ne prendre en compte que des couples de valeurs obtenus pendant des démarrages survenant après une période de repos de durée prédéterminée de ladite association de batterie (4) de chaîne de démarrage (2) et de moteur à combustion interne (1).

11. Procédé suivant l'une quelconque des revendications 2 à 10, **caractérisé en ce qu'**il consiste à ne prendre en compte que des couples de valeurs obtenus pendant des démarrages pour lesquels la tension en circuit ouvert de ladite batterie indique une charge de celle-ci, jugée suffisante.

12. Procédé suivant la revendication 10, **caractérisé en ce que** ladite période de repos est d'au moins huit heures.

13. Procédé suivant l'une quelconque des revendications 1 à 12, **caractérisé en ce que** ledit moteur (1) étant de type à allumage commandé, ladite vitesse de démarrage électrique minimale est de 100 tours/minute, environ.

14. Procédé suivant l'une quelconque des revendications 1 à 12, **caractérisé en ce que** ledit moteur (1) étant de type Diesel, ladite vitesse de démarrage minimale est de 130 tours/minutes, environ.

15. Dispositif de mise en oeuvre du procédé de diagnostic de l'aptitude à fonctionner d'une batterie d'accumulateurs selon l'une quelconque des revendications précédentes, **caractérisé en ce qu'**il comporte
différents équipements électriques tels qu'une chaîne de démarrage, un moteur à combustion interne (1) qui fournit une information de la température du moteur Tmot, une batterie (4) fournissant l'énergie et la puissance à ladite chaîne de démarrage (2), de sorte que ladite chaîne de démarrage puisse au minimum faire tourner ledit moteur à combustion interne (1) à une vitesse minimale de démarrage préfixée, à une température minimale de démarrage initialement déterminée, ladite batterie fournissant une information de la tension batterie Ubatt, un calculateur (5) qui fournit une information de la vitesse de démarrage électrique dudit moteur (1), et un dispositif d'affichage (14) pour afficher une information de diagnostic à l'utilisateur du véhicule,
et un dispositif de diagnostic (7) comprenant des moyens de mémorisation (15) comportant deux tables caractéristiques (16) et (17) dans lesquelles sont déposées respectivement une courbe typique (CT) et une courbe de référence (CR), et un calculateur qui détermine une nouvelle température minimale de démarrage à laquelle serait atteinte ladite vitesse minimale de démarrage préfixée en fonction des informations reçues et de la courbe (CR).

## Claims

1. Method for diagnosing the operability of an accumulator battery (4) for a motor vehicle comprising the association of an internal combustion engine (1), of a starting chain (2) and of the said battery (4), the latter providing the energy and the power to the said starting chain (2), so that the said starting chain can at the minimum turn the said internal combustion engine (1) at a preset minimum starting speed, at an initially determined minimum starting temperature, **characterized in that** it consists
in recomputing, along with the startings of the vehicle, a new minimum starting temperature at which the said preset minimum starting speed would be attained, so as to establish the diagnosis of the said battery on the basis of the evolution, increasing in the course of the use of the said battery, of the said recomputed new minimum starting temperature.

2. Method in accordance with Claim 1, **characterized in that** it consists:
a) in storing, for a given association of a type of battery (4), of a type of starting chain (2) and of a type of internal combustion engine (1), a reference curve (CR) plotted for the said battery in the brand new state, as a function of a plurality of pairs of values of starting temperature and of speed of rotation of electrical starting, this reference curve comprising in particular a pair of values including the said preset speed and the said minimum temperature,
b) in the course of at least one starting of the said association, in logging a pair of current values of starting temperature and of speed of rotation of electrical starting of the said engine,
c) in computing on the basis of a curve of pairs of values, homothetic to the said reference curve (CR), on which the said pair of current values is placed, the new minimum starting temperature at which the said preset speed would be attained, and
d) in making a diagnosis about the operability of the said battery (4) as a function of the discrepancy between the minimum temperature value of the said reference curve (CR) and the computed new minimum temperature.

3. Method in accordance with Claim 2, **characterized in that**, the said association of a battery (4), of a starting chain (2) and of an internal combustion engine (1) having just been constructed on the basis of brand new components, it consists in experimentally plotting the said reference curve (CR) on a specimen of such an association.

4. Method in accordance with Claim 2, **characterized in that**, the said association of a battery (4), of a starting chain (2) and of an internal combustion engine (1) having just been constructed on the basis of brand new components, it consists on the occasion of this construction, in storing an empirical typical curve (CT) formed of a plurality of pairs of values each composed of a temperature and of a relative value of speed of electrical starting that is experimentally associated with this temperature,
in storing the said reference curve (CR) in the course of a learning period subsequent to the said construction by determining for a predetermined number of starts current learning pairs for temperature and speed of electrical starting,
in computing on a homothetic curve of the said typical curve and on the basis of at least some of the said current learning pairs thus logged, respective pairs composed of values repesentative of the said minimum temperature and of the said preset speed,
in establishing the mean of the temperature values of the said respective pairs of minimum temperature and of preset speed and
in fixing the said reference curve (CR) by homothety with respect to the said typical curve (CT), on the mean thus obtained.

5. Method in accordance with Claim 4, **characterized in that** the said learning period extends over a number of starts lying between 20 and 100.

6. Method in accordance with any one of Claims 2 to 5, **characterized in that** it consists in fixing the said reference curve (CR) on the said mean, when the discrepancy between the mean established during a given start and the mean established in the course of the first start taken into account drops shy of a predetermined threshold.

7. Method in accordance with Claim 6, **characterized in that**, the value of the said discrepancy remaining beyond the said threshold for a predetermined number of starts, there is undertaken the establishment of a new initial mean and the said reference curve (CR) is fixed when the discrepancy between the mean established during a given start and the new initial mean drops shy of a predetermined threshold.

8. Method in accordance with Claim 7, **characterized in that** it consists in emitting a defect message when the number of initial means computed exceeds a predetermined value.

9. Method in accordance with any one of Claims 2 to 8, **characterized in that** it consists in taking into account only pairs of values obtained during starts performed after elapsing of a period of running in of the said association of battery (4), of starting chain (2) and of internal combustion engine (1), in such a way that all the components of this association have the same temperature.

10. Method in accordance with any one of Claims 2 to 9, **characterized in that** it consists in taking into account only pairs of values obtained during starts occurring after a rest period of predetermined duration of the said association of battery (4), of starting chain (2) and of internal combustion engine (1).

11. Method in accordance with any one of Claims 2 to 10, **characterized in that** it consists in taking into account only pairs of values obtained during starts for which the open-circuit voltage of the said battery indicates a charge of the latter, judged sufficient.

12. Method in accordance with Claim 10, **characterized in that** the said rest period is at least eight hours.

13. Method in accordance with any one of Claims 1 to 12, **characterized in that** the said engine (1) being of controlled ignition type, the said minimum electrical starting speed is about 100 revolutions/minute.

14. Method in accordance with any one of Claims 1 to 12, **characterized in that** the said engine (1) being of Diesel type, the said minimum starting speed is about 130 revolutions/minute.

15. Device for implementing the method of diagnosing the operability of an accumulator battery according to any one of the preceding claims, **characterized in that** it comprises
various items of electrical equipment such as a starting chain, an internal combustion engine (1) which provides a piece of information regarding the temperature of the engine Teng, a battery (4) providing the energy and the power to the said starting chain (2), so that the said starting chain can at the minimum turn the said internal combustion engine (1) at a preset minimum starting speed, at an initially determined minimum starting temperature, the said battery providing a piece of information regarding the battery voltage Ubatt, a computer (5) which provides a piece of information regarding the electrical starting speed of the said engine (1), and a display device (14) for displaying a piece of diagnostic information to the user of the vehicle,
and a diagnostic device (7) comprising storage means (15) comprising two characteristic tables (16) and (17) in which are deposited respectively a typical curve (CT) and a reference curve (CR), and a computer which determines a new minimum starting temperature at which the said preset minimum starting speed would be attained as a function of the information received and of the curve (CR).

## Patentansprüche

1. Verfahren zur Diagnose der Betriebsfähigkeit einer Akkumulatorenbatterie (4) für ein Kraftfahrzeug, das die Vereinigung eines Verbrennungsmotors (1), eines Anlasserstrangs (2) und der Batterie (4) enthält, wobei diese dem Anlasserstrang (2) die Energie und die Leistung liefert, damit der Anlasserstrang mindestens den Verbrennungsmotor (1) mit einer vorab festgelegten Anlassmindestgeschwindigkeit bei einer anfangs bestimmten Anlassmindesttemperatur drehen lassen kann, **dadurch gekennzeichnet, dass** es darin besteht,
je nach den Anlassvorgängen des Fahrzeugs eine neue Anlassmindesttemperatur neu zu berechnen, bei der die vorab festgelegte Anlassmindestgeschwindigkeit erreicht würde, um die Diagnose der Batterie auf der Basis der Entwicklung, zunehmend im Laufe der Nutzung der Batterie, der neu berechneten neuen Anlassmindesttemperatur zu erstellen.

2. Verfahren nach Anspruch 1, **dadurch gekennzeichnet, dass** es darin besteht:
a) für eine gegebene Vereinigung eines Batterietyps (4), eines Anlassstrangtyps (2) und eines Verbrennungsmotortyps (1) eine Bezugskurve (CR) zu speichern, die für die Batterie im Neuzustand gezeichnet wird, abhängig von mehreren Wertepaaren aus Anlasstemperatur und elektrischer Anlassdrehgeschwindigkeit, wobei diese Bezugskurve insbesondere ein Wertepaar enthält, das die vorab festgelegte Geschwindigkeit und die Mindesttemperatur umfasst,
b) während mindestens eines Anlassvorgangs der Vereinigung, ein Paar von aktuellen Werten der Anlasstemperatur und der elektrischen Anlassdrehgeschwindigkeit des Motors zu erfassen,
c) auf der Basis einer Kurve von Wertepaaren, die zur Bezugskurve (CR) homothetisch ist, auf der das Paar von aktuellen Werten angeordnet ist, die neue Anlassmindesttemperatur zu berechnen, bei der die vorab festgelegte Geschwindigkeit erreicht würde, und
d) eine Diagnose der Betriebsfähigkeit der Batterie (4) abhängig von der Abweichung zwischen dem Mindesttemperaturwert der Bezugskurve (CR) und der neuen berechneten Mindesttemperatur zu erstellen.

3. Verfahren nach Anspruch 2, **dadurch gekennzeichnet, dass** es, wenn die Vereinigung einer Batterie (4), eines Anlassstrangs (2) und eines Verbrennungsmotors (1) ausgehend von neuen Bauteilen gebildet wurde, darin besteht, die Bezugskurve (CR) experimentell an einem Exemplar einer solchen Vereinigung zu zeichnen.

4. Verfahren nach Anspruch 2, **dadurch gekennzeichnet, dass** es, wenn die Vereinigung einer Batterie (4), eines Anlasserstrangs (2) und eines Verbrennungsmotors (1) ausgehend von neuen Bauteilen gebildet wurde, darin besteht, bei dieser Bildung eine typische empirische Kurve (CT) zu speichern, die aus mehreren Wertepaaren geformt wird, die je aus einer Temperatur und einem relativen elektrischen Anlassgeschwindigkeitswert bestehen, der dieser Temperatur experimentell zugeordnet wird,
die Bezugskurve (CR) im Laufe einer Lernzeit nach der Bildung zu speichern, indem während einer vorbestimmten Anzahl von Anlassvorgängen aktuelle Lernpaare der Temperatur und der elektrischen Anlassgeschwindigkeit bestimmt werden,
in einer homothetischen Kurve der typischen Kurve und ausgehend von mindestens bestimmten der so erfassten aktuellen Lernpaare Paare zu berechnen, die aus repräsentativen Werten der Mindesttemperatur und der vorab festgelegten Geschwindigkeit bestehen,
den Mittelwert der Temperaturwerte der Paare von Mindesttemperatur und vorab festgelegter Geschwindigkeit zu erstellen, und
die Bezugskurve (CR) durch Homothetie bezüglich der typischen Kurve (CT) auf den so erhaltenen Mittelwert zu fixieren.

5. Verfahren nach Anspruch 4, **dadurch gekennzeichnet, dass** die Lernzeit sich über eine Anzahl von Anlassvorgängen erstreckt, die zwischen 20 und 100 liegt.

6. Verfahren nach einem der Ansprüche 2 bis 5, **dadurch gekennzeichnet, dass** es darin besteht, die Bezugskurve (CR) auf den Mittelwert zu fixieren, wenn die Abweichung zwischen dem während eines gegebenen Anlassvorgangs erstellten Mittelwert und dem während des ersten berücksichtigten Anlassvorgangs erstellten Mittelwert sich unter eine vorbestimmte Schwelle reduziert.

7. Verfahren nach Anspruch 6, **dadurch gekennzeichnet, dass**, wenn der Wert der Abweichung während einer vorbestimmten Anzahl von Anlassvorgängen über der Schwelle bleibt, die Erstellung eines neuen Anfangsmittelwerts durchgeführt wird, und die Bezugskurve (CR) fixiert wird, wenn die Abweichung zwischen dem während eines gegebenen Anlassvorgangs erstellten Mittelwert und dem neuen Anfangsmittelswert sich unter eine vorgegebene Schwelle reduziert.

8. Verfahren nach Anspruch 7, **dadurch gekennzeichnet, dass** es darin besteht, eine Fehlermitteilung auszugeben, wenn die Anzahl von berechneten Anfangsmittelwerten einen vorbestimmten Wert überschreitet.

9. Verfahren nach einem der Ansprüche 2 bis 8, **dadurch gekennzeichnet, dass** es darin besteht, nur Wertepaare zu berücksichtigen, die während Anlassvorgängen erhalten werden, die nach Ablauf einer Einfahrzeit der Vereinigung aus Batterie (4), Anlasserstrang (2) und Verbrennungsmotor (1) durchgeführt werden, damit alle Bauteile dieser Vereinigung die gleiche Temperatur haben.

10. Verfahren nach einem der Ansprüche 2 bis 9, **dadurch gekennzeichnet, dass** es darin besteht, nur Wertepaare zu berücksichtigen, die während Anlassvorgängen erhalten werden, die nach einer Ruhezeit vorbestimmter Dauer der Vereinigung von Batterie (4), Anlasserstrang (2) und Verbrennungsmotor (1) auftreten.

11. Verfahren nach einem der Ansprüche 2 bis 10, **dadurch gekennzeichnet, dass** es darin besteht, nur Wertepaare zu berücksichtigen, die während Anlassvorgängen erhalten werden, bei denen die Leerlaufspannung der Batterie eine Ladung dieser Batterie anzeigt, die als ausreichend angesehen wird.

12. Verfahren nach Anspruch 10, **dadurch gekennzeichnet, dass** die Ruhezeit mindestens acht Stunden beträgt.

13. Verfahren nach einem der Ansprüche 1 bis 12, **dadurch gekennzeichnet, dass**, wenn der Motor (1) vom Typ mit Fremdzündung ist, die elektrische Anlassmindestgeschwindigkeit etwa 100 Umdrehungen/Minute beträgt.

14. Verfahren nach einem der Ansprüche 1 bis 12, **dadurch gekennzeichnet, dass**, wenn der Motor (1) vom Typ Diesel ist, die Anlassmindestgeschwindigkeit etwa 130 Umdrehungen/Minute beträgt.

15. Vorrichtung zur Anwendung des Verfahrens zur Diagnose der Betriebsfähigkeit einer Akkumulatorenbatterie nach einem der vorhergehenden Ansprüche, **dadurch gekennzeichnet, dass** sie aufweist
verschiedene elektrische Geräte wie einen Anlasserstrang, einen Verbrennungsmotor (1), der eine Information über die Temperatur des Motors Tmot liefert, eine Batterie (4), die die Energie und die Leistung an den Anlasserstrang (2) liefert, damit der Anlasserstrang mindestens den Verbrennungsmotor (1) mit einer vorab festgelegten Anlassmindestgeschwindigkeit bei einer anfangs bestimmten Anlassmindesttemperatur drehen lassen kann, wobei die Batterie eine Information über die Batteriespannung Ubatt liefert, einen Rechner (5), der eine Information über die elektrische Anlassgeschwindigkeit des Motors (1) liefert, und eine Anzeigevorrichtung (14), um dem Benutzer des Fahrzeugs eine Diagnoseinformation anzuzeigen,
und eine Diagnosevorrichtung (7), die Speichereinrichtungen (15) enthält, die zwei charakteristische Tabellen (16) und (17) aufweisen, in denen eine typische Kurve (CT) bzw. eine Bezugskurve (CR) untergebracht sind, und einen Rechner, der eine neue Anlassmindesttemperatur bestimmt, bei der die vorab festgelegte Anlassmindestgeschwindigkeit erreicht würde, abhängig von den empfangenen Informationen und der Kurve (CR).
